# EUROPÄISCHE PATENTSCHRIFT

(11) **EP 3 722 926 B1**
(45) Veröffentlichungstag und Bekanntmachung des Hinweises auf die Patenterteilung: **30.06.2021**
(21) Anmeldenummer: 19167733.5
(22) Anmeldetag: 08.04.2019
(51) Int. Cl.: G06F 1/18, H05K 5/00, H05K 5/02

(54) **GEHÄUSE FÜR EIN MEDIZINTECHNISCHES GERÄT**
HOUSING FOR A MEDICAL DEVICE
BOÎTIER POUR UN APPAREIL MÉDICAL

(43) Veröffentlichungstag der Anmeldung: 14.10.2020
(73) Patentinhaber: Adlink Technology GmbH, 94469 Deggendorf (DE)
(72) Erfinder: Steinbeißer, Walter, 94432 Pilsting (DE)
(74) Vertreter: Wolf, Gerhard

(56) Entgegenhaltungen:
- EP-A1- 3 425 476
- DE-A1- 19 646 009
- US-A1- 2014 105 682

## Beschreibung

Die Erfindung betrifft ein Gehäuse für ein medizintechnisches Gerät, eine Entsicherungseinrichtung für ein Gehäuse sowie ein Verfahren zum Öffnen eines solchen Gehäuses.

Medizintechnische Geräte, beispielsweise Monitore oder Computer, bei denen Rechnerhardware wie Prozessor, Speicher etc. sowie eine berührungsempfindliche Anzeigeeinheit in ein gemeinsames Gehäuse integriert sind, sind allgemein bekannt. Derartige medizintechnische Geräte finden insbesondere in Operationssälen, medizinischen Schleusenbereichen und Intensivstationen Verwendung. Diese Geräte müssen daher hohe Anforderungen an Reinigbarkeit und Sterilisierbarkeit erfüllen. Zudem müssen die Gehäuse der Geräte auch mit Flüssigkeiten sterilisiert werden können, so dass die Gehäuse gegen Eindringen von Feuchtigkeit geschützt werden müssen.

Gehäuse von medizintechnischen Geräten sind zumeist mehrteilig ausgebildet, wobei die Gehäuseteile lösbar miteinander verbunden sein sollen, um Reparaturen des Geräts zu ermöglichen.

Nachteilig an den bekannten Gehäusen ist, dass diese zur mechanischen Sicherung der lösbar miteinander verbundenen Gehäuseteile Schraubverbindungen aufweisen. Die Schraubenköpfe der Schraubverbindungen und die Konturen um diese Schraubenköpfe herum sind schwer reinigbar bzw. desinfizierbar, so dass Gehäuse mit derartigen Schraubverbindungen aus hygienischen Gründen unerwünscht sind.

Die Druckschrift EP 3 425 476 A1 offenbart ein Gehäuse für einen Computer mit einem Touchscreen.

Die Druckschrift DE 196 46 009 A1 offenbart eine Verschlussvorrichtung für ein Gehäuse.

Die Druckschrift US 2014/0105682 A1 offenbart eine Technologie zur Fixierung von Objekten untereinander.

Ausgehend hiervon ist es Aufgabe der Erfindung, ein Gehäuse für ein medizintechnisches Gerät anzugeben, das trotz lösbar miteinander verbundener Gehäuseteile eine verbesserte Reinigung und Desinfizierung des Gehäuses ermöglicht.

Die Aufgabe wird durch ein Gehäuse mit den Merkmalen des unabhängigen Patentanspruchs 1 gelöst. Bevorzugte Ausführungsformen sind Gegenstand der Unteransprüche.

Gemäß einem ersten Aspekt bezieht sich die Erfindung auf ein Gehäuse für ein medizintechnisches Gerät. Das Gerät ist ein Monitor oder ein sog. Medical PC, d.h. ein Computer für die Verwendung in medizinischen Behandlungsräumen, bei dem die Rechnerhardware wie beispielsweise ein Prozessor, ein Speicher etc. sowie eine berührungsempfindliche Anzeigeeinheit in ein gemeinsames Gehäuse integriert sind. Das Gehäuse umfasst zumindest eine berührungsempfindliche Anzeigeeinheit oder eine mechanische Aufnahme für eine solche berührungsempfindliche Anzeigeeinheit. Das Gehäuse ist vorzugsweise derart ausgebildet, dass sich die Anzeigeeinheit über die komplette oder im Wesentlichen komplette Frontseite des Gehäuses erstreckt. Das Gehäuse umfasst zumindest einen ersten Gehäuseteil und einen mit dem ersten Gehäuseteil lösbar verbindbaren zweiten Gehäuseteil. Der erste Gehäuseteil weist erste Verbindungsmittel und der zweite Gehäuseteil mit diesen ersten Verbindungsmitteln beim Koppeln dieser Gehäuseteile zusammenwirkende zweite Verbindungsmittel auf.

Die ersten und zweiten Verbindungsmittel sind dazu ausgebildet, eine Fixierung des zweiten Gehäuseteils am ersten Gehäuseteil durch eine formschlüssige Verbindung zu bewirken. Eine derartige formschlüssige Verbindung ist beispielsweise eine verhakende oder auf andere Weise ineinander eingreifende Verbindung der Gehäuseteile. Es sind Sicherungsmittel vorgesehen, die zur Sicherung der Fixierung des zweiten Gehäuseteils am ersten Gehäuseteil ausgebildet sind. Die Sicherungsmittel weisen ein magnetisches oder magnetisierbares Element auf, das zum Zusammenwirken mit einer magnetischen Entsicherungseinrichtung ausgebildet ist, und zwar derart, dass die Sicherungsmittel durch das Magnetfeld der magnetischen Entsicherungseinrichtung aus einer Sicherungsstellung in eine Entsicherungsstellung bewegbar sind. Das magnetische Element kann insbesondere ein Permanentmagnet sein. Das magnetisierbare Element kann ein Element sein, das ferromagnetische Eigenschaften aufweist, beispielsweise ein Element aus Eisen. Die Sicherung der Fixierung des zweiten Gehäuseteils am ersten Gehäuseteil erfolgt vorzugsweise schraubenlos und beispielsweise ausschließlich durch diese Sicherungsmittel. Die Sicherungsmittel sind vorzugsweise in das Gehäuse integriert und verdeckt liegend.

Der technische Vorteil des erfindungsgemäßen Gehäuses besteht darin, dass aufgrund der magnetisch betätigbaren Sicherungsmittel auf Schrauben zur Sicherung der Fixierung des zweiten Gehäuseteils am ersten Gehäuseteil verzichtet werden kann, was die Reinigbarkeit und Desinfizierbarkeit des Gehäuses wesentlich erleichtert.

Gemäß einem Ausführungsbeispiel weisen die Sicherungsmittel einen Riegel auf, der federbelastet ohne Einwirkung äußerer Kräfte in eine Sicherungsstellung positioniert ist. Der Riegel kann beispielsweise durch einen pin-artig ausgebildeten Bolzen gebildet sein, der verschiebbar oder in anderer Weise beweglich in einem Teil des Gehäuses, beispielsweise dem ersten Gehäuseteil, der zur Aufnahme der berührungsempfindlichen Anzeigeeinheit ausgebildet ist, vorgesehen ist. Durch diesen Riegel und dessen federbedingte Vorspannung in die Sicherungsstellung wird erreicht, dass das erste und zweite Gehäuseteil gegen unerwünschtes Lösen der formschlüssigen Verbindung gesichert ist und aktiv die Sicherungsmittel deaktiviert werden müssen, um die formschlüssige Verbindung lösen zu können.

Gemäß einem Ausführungsbeispiel ist der Riegel verschiebbar, insbesondere durch eine translatorische Bewegung in Richtung dessen Längsachse verschiebbar, verschwenkbar oder in einer kombinierten Schiebe-Schwenkbewegung bewegbar. Mittels dieser Bewegung kann der Riegel aus der Sicherungsstellung in die Entsicherungsstellung bewegt werden und umgekehrt.

Gemäß einem Ausführungsbeispiel ist der Riegel mit dem magnetischen oder magnetisierbaren Element mechanisch gekoppelt, wobei das magnetische oder magnetisierbare Element zum Zusammenwirken mit der magnetischen Entsicherungseinrichtung ausgebildet ist, und zwar derart, dass durch die von der magnetischen Entsicherungseinrichtung auf das magnetische oder magnetisierbare Element ausgeübten Kräfte der Riegel aus Sicherungsstellung in die Entsicherungsstellung bewegbar ist. Dadurch kann ausgelöst durch die magnetische Entsicherungseinrichtung die durch den Riegel bewirkte Verbindungssicherung deaktiviert werden, so dass die formschlüssige Verbindung der Gehäuseteile gelöst werden kann.

Gemäß einem Ausführungsbeispiel ist der Riegel in der Sicherungsstellung zum Eingreifen in eine am zweiten Gehäuseteil ausgebildete Ausnehmung vorgesehen oder der Riegel hintergreift in der Sicherungsstellung einen Vorsprung oder eine Hinterschneidung, die am zweiten Gehäuseteil vorgesehen ist. Durch dieses Eingreifen bzw. Hintergreifen wird eine mechanische Sicherung zwischen dem ersten Gehäuseteil, in dem der Riegel gelagert ist, und dem zweiten Gehäuseteil erreicht.

Gemäß einem Ausführungsbeispiel weist das erste Gehäuseteil als erste Verbindungsmittel Öffnungen auf, in die am zweiten Gehäuseteil als zweite Verbindungsmittel vorgesehene Vorsprünge formschlüssig eingreifen. Alternativ ist eine inverse Ausbildung denkbar, nämlich dass das zweite Gehäuseteil als zweite Verbindungsmittel Öffnungen aufweist, in die am ersten Gehäuseteil als erste Verbindungsmittel vorgesehene Vorsprünge formschlüssig eingreifen. Dadurch lässt sich eine sichere Fixierung der Gehäuseteile relativ zueinander erreichen. Vorzugsweise werden die Gehäuseteile durch die formschlüssige Verbindung gegeneinander angepresst, so dass die Schnittstelle zwischen den Gehäuseteilen flüssigkeitsdicht ausgebildet werden kann.

Gemäß einem Ausführungsbeispiel erfolgt die formschlüssige Verbindung zwischen dem zweiten Gehäuseteil und dem ersten Gehäuseteil durch einen abschnittsweise eine Hinterschneidung hintergreifenden Vorsprung. Der Vorsprung kann dabei um dessen Längsachse rotationssymmetrisch ausgebildet sein und beispielsweise einen Zapfen ausbilden. Dadurch kann eine sichere Fixierung der Gehäuseteile relativ zueinander erreicht werden.

Gemäß einem Ausführungsbeispiel erfolgt die formschlüssige Verbindung zwischen dem zweiten Gehäuseteil und dem ersten Gehäuseteil durch mehrere pilzkopfförmige oder schwalbenschwanzartig ausgebildete Vorsprünge, die in mit diesen Vorsprüngen zusammenwirkende Ausnehmungen oder Öffnungen eingreifen. Dadurch lässt sich eine Fixierung der Gehäuseteile, insbesondere ein gegeneinander angepresstes Fixieren der Gehäuseteile relativ zueinander erreichen.

Gemäß der beanspruchten Erfindung ist der zweite Gehäuseteil am ersten Gehäuseteil durch Aufsetzen in einer ersten Raumrichtung und durch Verschieben in einer zweiten, quer zur ersten Raumrichtung verlaufenden Raumrichtung fixierbar. Die zweite Raumrichtung verläuft vorzugsweise parallel oder im Wesentlichen parallel zu der Ebene, die durch die Längs-und Breitseite des ersten Gehäuseteils aufgespannt wird, d.h. der Ebene in der die Anzeigeeinheit angeordnet ist. Beispielsweise können beim Aufsetzen des zweiten Gehäuseteils Vorsprünge in damit korrespondierende Öffnungen eingesetzt werden. Durch das anschließende Verschieben entlang der zweiten Raumrichtung kann der Vorsprung in einen verjüngten Bereich der Öffnung verschoben werden, wodurch die formschlüssige Verbindung erreicht wird.

Gemäß einem Ausführungsbeispiel verlaufen die erste und zweite Raumrichtung senkrecht zueinander. Dadurch wird erreicht, dass der zweite Gehäuseteil durch die Sicherungsmittel technisch einfach gesichert werden kann, da durch die Sicherungsmittel lediglich das Verschieben des Gehäuseteils in der zweiten Raumrichtung unterbunden werden muss.

Gemäß der beanspruchten Erfindung ist an der Schnittstelle zwischen dem ersten und zweiten Gehäuseteil eine Dichtung vorgesehen, die bei Fixierung des zweiten Gehäuseteils am ersten Gehäuseteil die Schnittstelle flüssigkeitsdicht abdichtet. Durch die formschlüssige Verbindung der Gehäuseteile gegeneinander wird ein Anpressdruck der Gehäuseteile gegenüber dieser Dichtung erreicht, so dass die Schnittstelle zwischen den Gehäuseteilen fluiddicht, insbesondere gemäß dem IP65-Standard fluiddicht, ausgebildet ist.

Die Dichtung kann in einer umlaufenden Ausnehmung eines der Gehäuseteile angeordnet sein. Die Dichtung kann dabei in dieser Ausnehmung klemmend und/oder stoffschlüssig, beispielsweise durch Verkleben in dieser Ausnehmung gehalten sein.

Die Dichtung kann mit einem überwiegenden Anteil deren Höhe (größer 50% der Dichtungshöhe) in die Ausnehmung des Gehäuseteils hineinragen und mit deren kleineren Anteil (kleiner als 50% der Dichtungshöhe) über diese Ausnehmung vorstehen.

Die Dichtung kann eine im Querschnitt halbrunde Form aufweisen. Die aufgrund der halbrunden Form bestehende Abflachung liegt vorzugsweise gegenüber dem Boden der Ausnehmung an, in die die Dichtung eingesetzt ist. Der runde Abschnitt steht oberseitig über die Ausnehmung vor und bildet damit eine Dichtfläche aus, gegenüber der der weitere Gehäuseteil anliegt.

Gemäß einem Ausführungsbeispiel ist bei Fixierung des zweiten Gehäuseteils am ersten Gehäuseteil der Übergang zwischen dem ersten und zweiten Gehäuseteil flächenbündig ausgebildet. Dadurch kann die Reinigbarkeit und Sterilisierbarkeit des Gehäuses weiterhin verbessert werden.

Gemäß einem Ausführungsbeispiel ist am zweiten Gehäuseteil zumindest ein Anschlussbereich mit zumindest einer Steckverbindungsschnittstelle vorgesehen. Zum Verschließen des Anschlussbereichs ist ein Gehäusedeckel vorgesehen, der magnetisch am zweiten Gehäuseteil fixierbar ist. Dadurch kann eine leichte Zugänglichkeit der Steckverbindungsschnittstelle bei gleichzeitig hoher Reinigbarkeit des Gehäuses erreicht werden.

Ein weiterer nicht beanspruchter Aspekt betrifft eine Entsicherungseinrichtung für ein Gehäuse, das gemäß einem der zuvor beschrieben Ausführungsbeispiele ausgebildet ist. Die Entsicherungseinrichtung umfasst zumindest einen Anlageabschnitt, der zur formschlüssigen Anlage gegenüber zumindest einem Eckbereich oder einer Kante des ersten Gehäuseteils ausgebildet ist und ein zumindest zeitweise ein magnetisches Feld bewirkendes Magnetelement, beispielsweise einen Permanentmagneten oder einen Elektromagneten. Das Magnetelement ist dazu ausgebildet, mit dem magnetischen oder magnetisierbaren Element des Sicherungsmittels zusammenzuwirken, um das Sicherungsmittel durch das Magnetfeld des Magnetelements aus einer Sicherungsstellung in eine Entsicherungsstellung zu bewegen.

Ein nochmals weiterer nicht beanspruchter Aspekt betrifft ein Verfahren zum Öffnen eines Gehäuses, wobei das Gehäuse zumindest einen ersten Gehäuseteil und einen mit dem ersten Gehäuseteil lösbar verbindbaren zweiten Gehäuseteil umfasst. Es sind am Gehäuse Sicherungsmittel vorgesehen, die zur Sicherung der Fixierung des zweiten Gehäuseteils am ersten Gehäuseteil ausgebildet sind. Das Verfahren umfasst die folgenden Schritte:
- Anordnen des Gehäuses, bei dem eine Öffnung des ersten Gehäuseteils durch den zweiten Gehäuseteil verschlossen ist, an einer magnetischen Entsicherungseinrichtung;
- Bewegen der Sicherungsmittel von einer Sicherungsstellung in eine Entsicherungsstellung durch Einwirken eines Magnetfeldes der magnetischen Entsicherungseinrichtung auf die Sicherungsmittel;
- Öffnen des Gehäuses durch Abnehmen des zweiten Gehäuseteils vom ersten Gehäuseteil.

Die Ausdrücke "näherungsweise", "im Wesentlichen" oder "etwa" bedeuten im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung, solange sie in den Schutzbereich der angehängten Ansprüche fallen.

Auch wird der Inhalt der Ansprüche zu einem Bestandteil der Beschreibung gemacht.

Die Erfindung wird im Folgenden anhand der Figuren an Ausführungsbeispielen näher erläutert. Es zeigen:
- Fig. 1: beispielhaft ein Ausführungsbeispiel eines Gehäuses in einer rückseitigen, perspektivischen Ansicht;
- Fig. 2: beispielhaft eine Draufsichtdarstellung auf die Vorderseite des zweiten Gehäuseteils, an der das erste Gehäuseteil fixierbar ist;
- Fig. 3: beispielhaft eine Seitendarstellung eines zweiten Gehäuseteils;
- Fig. 4: beispielhaft eine Darstellung der Rückseite eines ersten Gehäuseteils, an der das zweite Gehäuseteil fixierbar ist;
- Fig. 5: beispielhaft eine Schnittdarstellung durch das erste Gehäuseteil entlang der Schnittlinie A-A gemäß Fig. 4;
- Fig. 6: beispielhaft eine Detaildarstellung der schlüssellochartigen Öffnung des ersten Gehäuseteils;
- Fig. 7: beispielhaft das mit X gekennzeichnete Detail gemäß Fig. 5 in einer vergrößerten Darstellung;
- Fig. 8: beispielhaft das mit Y gekennzeichnete Detail gemäß Fig. 5 in einer vergrößerten Darstellung;
- Fig. 9: beispielhaft eine perspektivische Darstellung eines in die Entsicherungseinrichtung eingelegten ersten Gehäuseteils mit einem in einer Explosionsdarstellung dargestellten Sicherungsmittel;
- Fig. 10: eine Detaildarstellung eines Eckbereichs des in die Entsicherungseinrichtung eingelegten ersten Gehäuseteils gemäß Fig. 9;
- Fig. 11: eine seitliche Schnittdarstellung eines in die Entsicherungseinrichtung eingelegten ersten Gehäuseteils mit darüber angeordnetem zweitem Gehäuseteil;
- Fig. 12: eine Darstellung vergleichbar der Figur 11 in einer perspektivischen Darstellung;
- Fig. 13: eine Detaildarstellung der formschlüssigen Verbindung zwischen dem ersten und zweiten Gehäuseteil, wobei ein pilzförmig ausgebildeter Zapfen im Eingriff mit einer schlüssellochartigen Öffnung steht;
- Fig. 14: beispielhaft das mit Z gekennzeichnete Detail gemäß Fig. 11 in einer vergrößerten Darstellung;
- Fig. 15: beispielhaft ein Gehäuse mit einem Anschlussbereich, bei dem die Magnetelemente in einer Explosionsdarstellung herausgelöst dargestellt sind;
- Fig. 16: beispielhaft ein zum Verschließen eines Anschlussbereichs vorgesehener Gehäusedeckel, bei dem die Magnetelemente in einer Explosionsdarstellung herausgelöst dargestellt sind;
- Fig. 17: beispielhaft das Gehäuse gemäß Fig. 15 mit einem abgenommenen Gehäusedeckel in einer Explosionsdarstellung; und
- Fig. 18: beispielhaft das Gehäuse gemäß Fig. 17 mit aufgesetztem Gehäusedeckel.

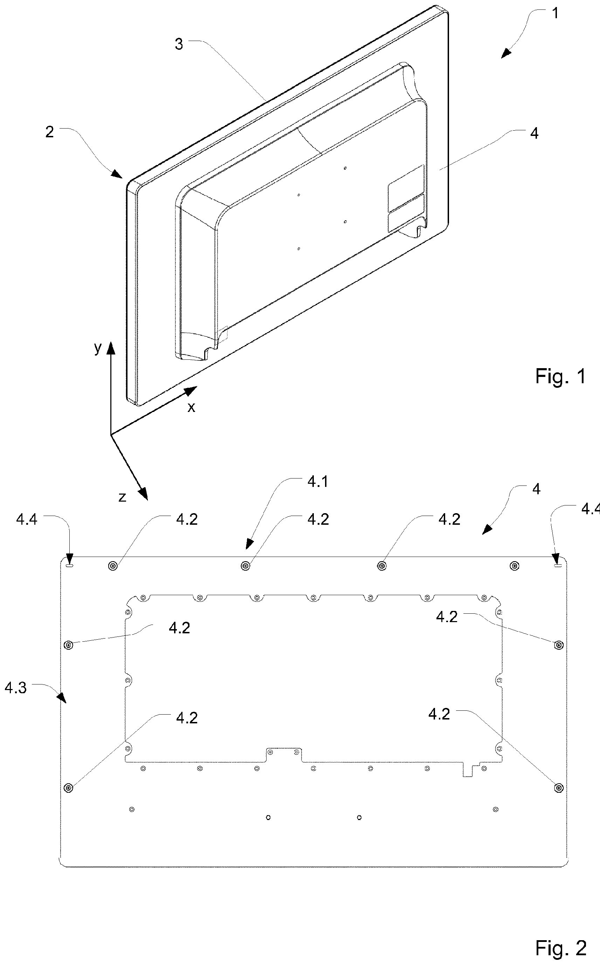

Fig. 1 zeigt ein Gehäuse 1 in einer perspektivischen Darstellung. Das Gehäuse 1 ist das Gehäuse eines medizintechnischen Geräts, nämlich einer berührungsempfindlichen Anzeigeeinheit bzw. eines Bildschirms oder einer Rechnereinheit, die eine solche Anzeigeeinheit bzw. einen solchen Bildschirm mit umfasst. In dem Gehäuse 1 ist somit zumindest eine Anzeigeeinheit 2 aufgenommen oder das Gehäuse 1 weist eine mechanische Aufnahme für ein solches Gehäuse auf.

Das Gehäuse 1 ist mehrteilig ausgebildet. Es umfasst einen ersten Gehäuseteil 3 und einen zweiten Gehäuseteil 4. Der erste Gehäuseteil 3 bildet beispielsweise einen rahmenartigen Gehäuseteil, in dem die Anzeigeeinheit 2 aufgenommen ist. Der zweite Gehäuseteil 4 ist ein auf der Rückseite des Gehäuses 1 anzuordnender Gehäuseteil, d.h. der zweite Gehäuseteil 4 ist rückseitig hinter der Anzeigeeinheit 2 angeordnet. Im geschlossenen Zustand des Gehäuses 1 sind der erste und zweite Gehäuseteil 3, 4 fest aber lösbar miteinander verbunden. Nachfolgend werden die mechanische Verbindung der Gehäuseteile 3, 4 und die Sicherungsmittel zur Sicherung des geschlossenen Zustands des Gehäuses 1 näher beschrieben.

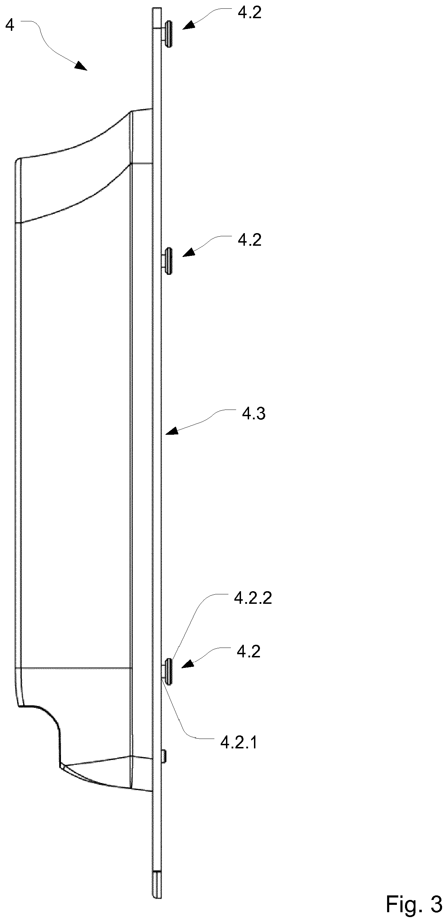

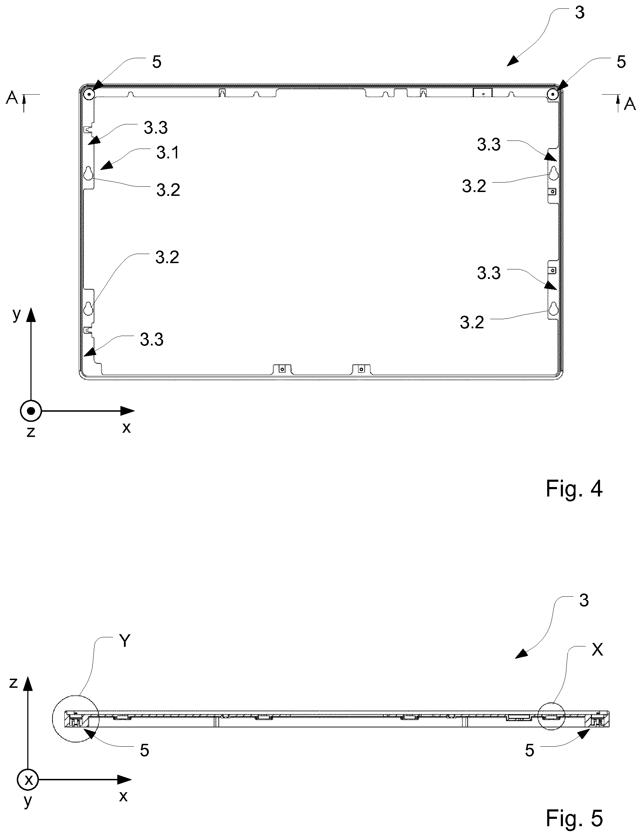

Die Figuren 2 und 3 zeigen das zweite Gehäuseteil 4, die Figuren 4 und 5 das erste Gehäuseteil 3 jeweils in unterschiedlichen Darstellungen. Zur lösbaren Verbindung des ersten und zweiten Gehäuseteil 3, 4 weisen der erste Gehäuseteil 3 erste Verbindungsmittel 3.1 und der zweite Gehäuseteil 4 zweite Verbindungsmittel 4.1 auf. Diese Verbindungsmittel 3.1, 4.1 sind derart ausgeformt, dass diese eine formschlüssige Verbindung zwischen dem ersten und zweiten Gehäuseteil 3, 4 ermöglichen. Die formschlüssige Verbindung wird durch ein Verhaken bzw. ein Verzahnen der Gehäuseteile 3, 4 ineinander ermöglicht.

Im gezeigten Ausführungsbeispiel gemäß den Figuren 2 bis 5 weist der zweite Gehäuseteil 4 als zweite Verbindungsmittel 4.1 Vorsprünge 4.2 auf. Der erste Gehäuseteil 3 weist als erste Verbindungsmittel 3.1 Öffnungen 3.2 auf, die mit diesen Vorsprüngen 4.2 beim Verschließen des Gehäuses 1 zusammenwirken, und zwar vorzugsweise derart, dass zwischen den Vorsprüngen 4.2 und den Öffnungen 3.2 eine formschlüssige Verbindung hergestellt wird.

Wie in den Figuren 2 und 3 erkennbar, sind die Vorsprünge 4.2 des zweiten Gehäuseteils 4 beispielsweise pilzkopfartig ausgebildete Zapfen. Diese weisen beispielsweise einen ersten Zapfenteil 4.2.1 und einen zweiten Zapfenteil 4.2.2 auf. Dabei ist der Durchmesser des ersten Zapfenteils 4.2.1 kleiner als der Durchmesser des zweiten Zapfenteil 4.2.2. Diese Zapfen bzw. Vorsprünge 4.2 stehen, wie in Figur 3 erkennbar, von einer Anlagefläche 4.3 insbesondere rechtwinklig ab. Dadurch können die Zapfen bzw. Vorsprünge 4.2 bei Anlage der Anlagefläche 3 gegenüber einer korrespondierenden Anlagefläche des ersten Gehäuseteils 3 in am ersten Gehäuseteil 3 vorgesehene Öffnungen 3.2 eingreifen.

Es versteht sich, dass die pilzkopf-förmige Ausbildung der Vorsprünge 4.2 lediglich ein Ausführungsbeispiel darstellt und dass weitere formschlüssige Verbindungsmöglichkeiten bestehen, beispielsweise schwalbenschwanzartige Verbindungen o.ä..

Die Figuren 4 und 5 zeigen die Ausbildung des ersten Gehäuseteils 3 mit dessen ersten Verbindungsmittel 3.1. Das erste Gehäuseteil 3 weist beispielsweise einen Anlagebereich 3.3 auf, gegenüber dem der zweite Gehäuseteil 4 zur Anlage gelangt. Dies schließt auch ein, dass der zweite Gehäuseteil 4 nicht unmittelbar sondern mittelbar über eine Dichtung 6 gegenüber dem Anlagebereich 3.3 anliegt.

Bei dem ersten Gehäuseteil 3 sind mit den Vorsprüngen 4.2 des zweiten Gehäuseteils 4 korrespondierende Öffnungen 3.2 vorgesehen. Dabei bedeutet "korrespondieren" in diesem Zusammenhang, dass die Öffnungen 3.2 derart am ersten Gehäuseteil 3 angeordnet sind, dass beim Aufsetzen des zweiten Gehäuseteils 4 auf das erste Gehäuseteil 3 (gemäß dem geltenden Koordinatensystem durch eine Aufsetzbewegung in negativer z-Richtung) die Vorsprünge 4.2 in die Öffnungen 3.2 einsetzbar sind. Die Öffnungen 3.2 sind dabei beispielsweise an zwei einander gegenüberliegenden Randbereichen des ersten Gehäuseteils 3, insbesondere dessen Schmalseiten, vorgesehen.

Die Öffnungen 3.2 sind mit deren Form an die Vorsprünge 4.2 des zweiten Gehäuseteil 4 angepasst. Im gezeigten Ausführungsbeispiel sind die Öffnungen 3.2 tropfenförmig bzw. schlüssellochartig ausgebildet, um mit den pilzkopfartig ausgebildeten Zapfen des zweiten Gehäuseteils 4 eine formschlüssige Verbindung herstellen zu können.

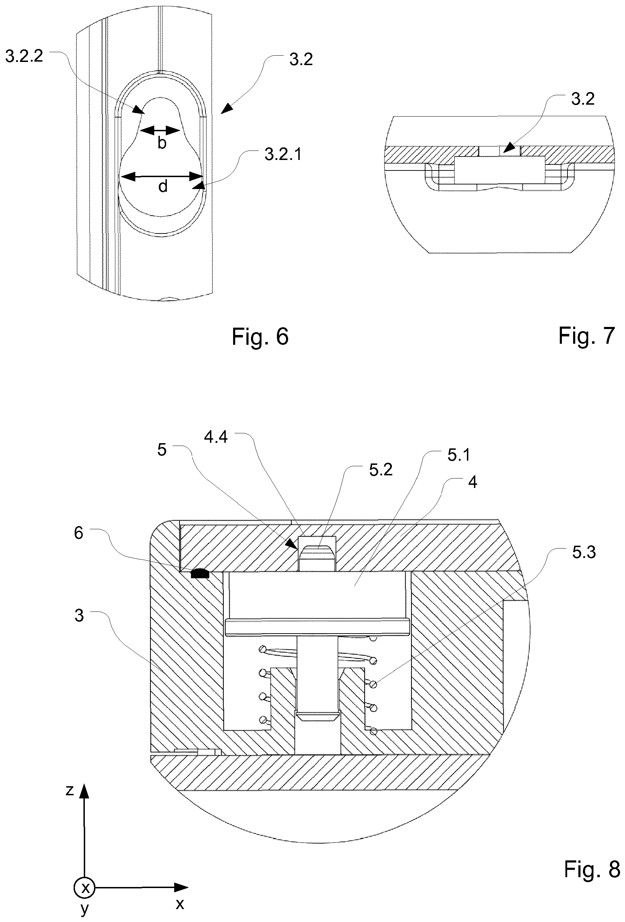

Mehr im Detail weisen, wie insbesondere in den Figuren 6 und 7 erkennbar, die Öffnungen 3.2 einen ersten Öffnungsabschnitt 3.2.1 und einen zweiten Öffnungsabschnitt 3.2.2 auf, der der sich in radialer Richtung vom ersten Öffnungsabschnitt 3.2.1 weg erstreckt. Dabei weist der erste Öffnungsabschnitt 3.2.1 einen Durchmesser d auf, der größer ist als die Breite b des zweiten Öffnungsabschnitts 3.2.2. Der Durchmesser d und die Breite b sind dabei derart gewählt, dass der zweite Zapfenteil 4.2.2 durch den ersten Öffnungsabschnitt 3.2.1 hindurchgesteckt werden kann (gemäß dem geltenden Koordinatensystem durch eine Aufsetzbewegung in negativer z-Richtung) und nach einer Verschiebebewegung des zweiten Gehäuseteils 4 in die Richtung, in die sich der zweite Öffnungsabschnitt 3.2.2 erstreckt (gemäß dem geltenden Koordinatensystem durch eine Schiebebewegung in positiver y-Richtung), der zweite Zapfenteil 4.2.2 den zweiten Öffnungsabschnitt 3.2.2 hintergreift, so dass dadurch eine formschlüssige Verbindung zwischen den Gehäuseteilen 3, 4 hergestellt wird.

Es versteht sich, dass die Form der Öffnungen 3.2 an die Form der Vorsprünge 4.2 angepasst sein muss. So müssen die Öffnungen 3.2 beispielsweise für den Fall, dass die Vorsprünge 4.2 schwalbenschwanzartig ausgebildet sind, eine mit dieser Schwalbenschwanzform korrespondierende Öffnungsform aufweisen.

Zur Vermeidung von Schraubverbindungen zwischen dem ersten und zweiten Gehäuseteil 3, 4 weist das Gehäuse 1 Sicherungsmittel 5 auf. Diese Sicherungsmittel sind beispielsweise verdeckt liegend ausgebildet, d.h. sind bei geschlossenem Gehäuse von außen nicht sichtbar.

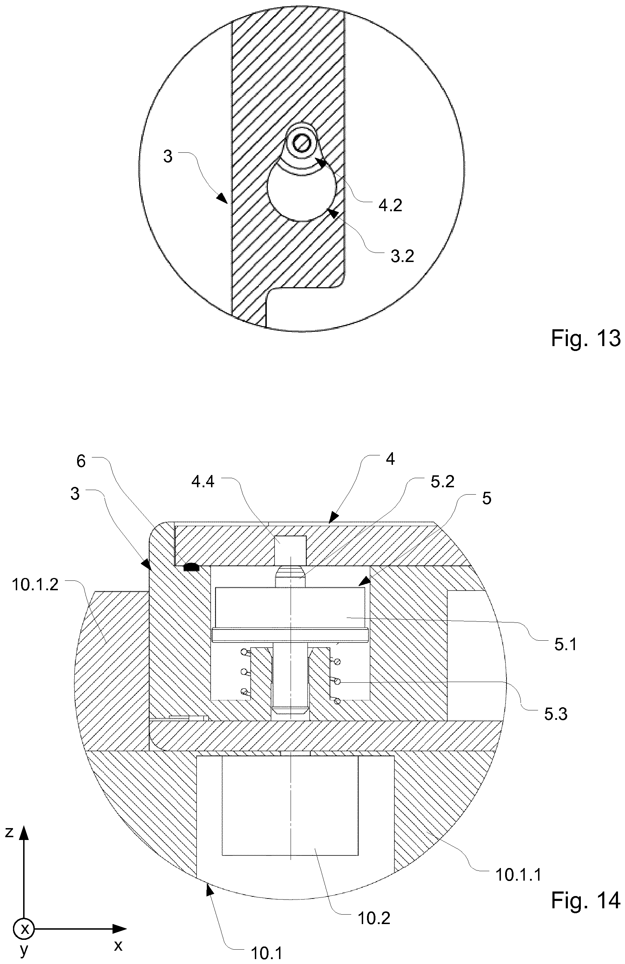

Die Sicherungsmittel 5 sind vorzugsweise dazu ausgebildet, zur Sicherung der formschlüssigen Verbindung zwischen dem ersten und zweiten Gehäuseteil 3, 4 eine Relativbewegung der Gehäuseteile 3, 4 zu verhindern, die zu einem Lösen dieser formschlüssigen Verbindung führen würde. Die Sicherungsmittel sind bewegbar im Gehäuse 1, insbesondere im ersten Gehäuseteil 3, gehalten und können durch eine Entsicherungseinrichtung 10 von einer Sicherungsstellung (in Fig. 8 gezeigt) in eine Entsicherungsstellung (in Fig. 14 gezeigt) bewegt werden.

Im gezeigten Ausführungsbeispiel weisen die Sicherungsmittel 5 einen Riegel 5.2 auf, der beweglich im ersten Gehäuseteil 3 gehalten ist. Alternativ wäre aber auch eine inverse Konfiguration grundsätzlich denkbar, nämlich dass die Sicherungsmittel 5 im zweiten Gehäuseteil 4 vorgesehen sind. Der Riegel 5.2 kann insbesondere von einer in Fig. 8 gezeigten Sicherungsstellung in eine in Fig. 14 gezeigte Entsicherungsstellung bewegt werden.

Im gezeigten Ausführungsbeispiel ist der Riegel 5.2 linear verschiebbar ausgebildet. Alternativ kann der Riegel 5.2 auch anderweitig bewegbar sein, beispielsweise verschwenkbar oder in einer kombinierten Linear-Schwenk-Bewegung. Der Riegel 5.2 ist im gezeigten Ausführungsbeispiel ein Verriegelungsbolzen.

Der Riegel 5.2 ist federbelastet in eine Sicherungsposition vorgespannt, die in Fig. 8 gezeigt ist. Hierzu ist beispielsweise eine den Riegel 5.2 umgebende Spiralfeder 5.3 vorgesehen, die mittels ihrer Federkraft den Riegel 5.2 in eine vorgeschobene Stellung (Sicherungsposition) drückt. In dieser Sicherungsposition ist der Riegel 5.2 bei aufgesetztem zweitem Gehäuseteil 4 zumindest abschnittsweise in eine Ausnehmung 4.4 des zweiten Gehäuseteils 4 eingeschoben. Durch dieses Eingreifen des Riegels 5.2 in die Ausnehmung 4.4 wird ein Verschieben des zweiten Gehäuseteils 4 relativ zum ersten Gehäuseteil 3 verhindert. Dies erfolgt insbesondere dadurch, dass der Riegel 5.2 in eine Richtung (z-Richtung) quer, insbesondere senkrecht, zur Verschieberichtung (y-Richtung), mittels der ein Lösen der formschlüssigen Verbindung zwischen erstem und zweitem Gehäuseteil 3, 4 erfolgt, bewegbar ist.

Die Sicherungsmittel 5 weisen ein Element 5.1 auf, das entweder selbst magnetisch ist, d.h. beispielsweise einen Permanentmagneten umfasst, oder zumindest aus einem ferromagnetischen Material, beispielsweise Eisen, Cobalt oder Nickel besteht, um mit einem Magnetelement 10.2 der magnetischen Entsicherungseinrichtung 10 zusammenwirken zu können.

Das magnetische oder magnetisierbare Element 5.1 ist im gezeigten Ausführungsbeispiel beispielsweise konzentrisch auf dem Riegel 5.2 aufgebracht und mit diesem verbunden. Wie nachfolgend näher beschrieben, ist das magnetische oder magnetisierbare Element 5.1 dazu vorgesehen, bei Anordnung eines Magnetelements 10.2 der magnetischen Entsicherungseinrichtung 10 unterhalb der Sicherungsmittel 5 den Riegel 5.2 aus der in Fig. 8 gezeigten Sicherungsstellung entgegen der Federkraft in die Entsicherungsstellung zu bewegen bzw. zu ziehen (Fig. 14). Dadurch wird der Riegel 5.2 aus der Ausnehmung 4.2 zurückgezogen und die formschlüssige Verbindung zwischen dem ersten und zweiten Gehäuseteil 3, 4 kann gelöst werden.

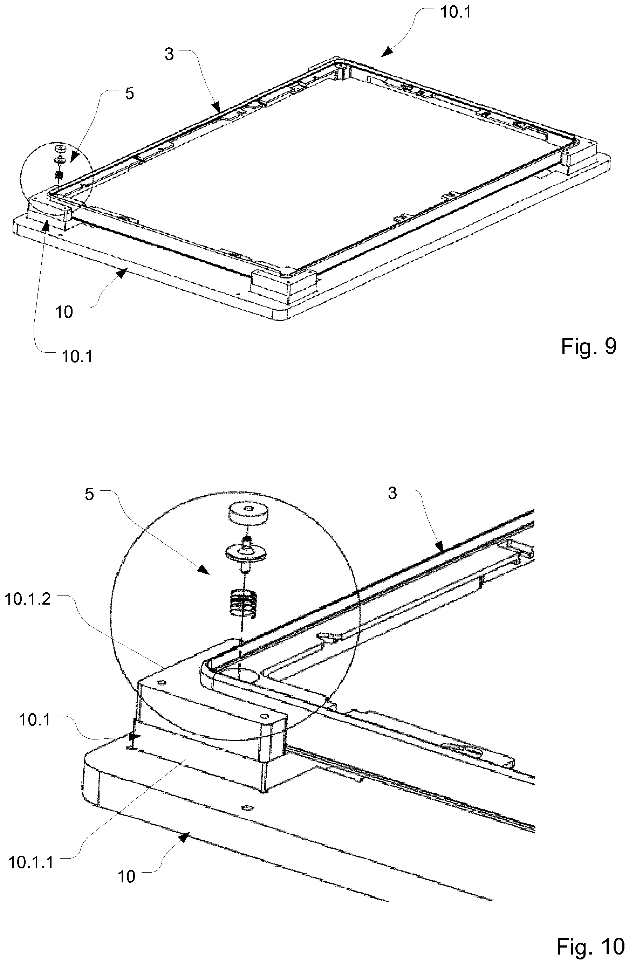

Fig. 10 zeigt die Sicherungsmittel 5 in einer Explosionsdarstellung. Die Sicherungsmittel umfassend den Riegel 5.2 und die Spiralfeder 5.3 sind in eine Ausnehmung im Eckbereich des ersten Gehäuseteils 3 eingebracht, wie dies im Zusammenschau mit Fig. 8 für einen Fachmann erkennbar ist.

Vorzugsweise sind mehrere Sicherungsmittel 5 an verschiedenen Positionen am Gehäuse 1 verteilt angeordnet. Wie in Fig. 4 ersichtlich, sind vorzugsweise zumindest zwei Sicherungsmittel 5 an den beiden gegenüberliegenden Seiten bzw. Eckbereichen des ersten Gehäuseteils 3 vorgesehen, um an beiden Seiten die Relativbewegung der Gehäuseteile 3, 4 durch Verschieben in y-Richtung blockieren zu können.

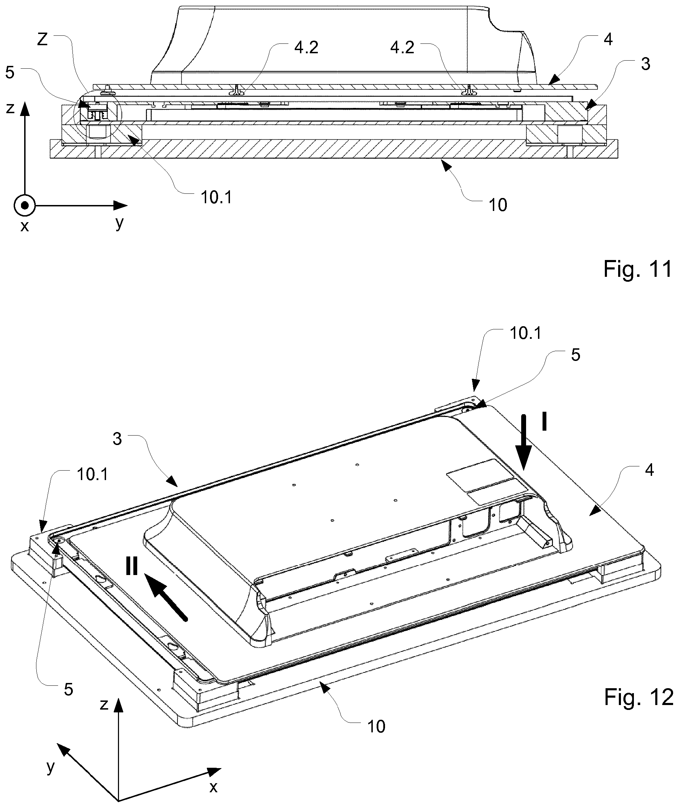

Im Folgenden wird anhand der Figuren 9 und Figuren 11 bis 14 der Vorgang des Verschließens des Gehäuse 1 durch Fixieren des zweiten Gehäuseteils 4 am ersten Gehäuseteil 3 beschrieben.

Zunächst wird der erste Gehäuseteil 3 in die magnetische Entsicherungseinrichtung 10 eingebracht oder eingelegt. Das Einlegen erfolgt beispielsweise derart, dass die in dem ersten Gehäuseteil 3 vorgesehene Anzeigeeinheit 2 der magnetischen Entsicherungseinrichtung 10 zugewandt ist. Die Entsicherungseinrichtung 10 weist einen Anlageabschnitt 10.1 auf, gegenüber dem der erste Gehäuseteil 3 beim Einlegen zur Anlage gelangt. Insbesondere umfasst der Anlageabschnitt 10.1 einen bodenseitigen Anlageabschnittsbereich 10.1.1 und einen seitlichen Anlageabschnittsbereich 10.1.2. Der bodenseitige Anlageabschnittsbereich bildet eine Anlagefläche gegenüber einer Vorderseite des ersten Gehäuseteils 3, in der die Anzeigeeinheit integriert ist. Der seitliche Anlageabschnittsbereich 10.1.2 hingegen bildet eine Art seitlichen Anschlag, gegenüber dem eine Seitenfläche oder ein Eckbereich des ersten Gehäuseteils 3 zur Anlage gelangt. Dadurch kann das erste Gehäuseteil 3 lagegenau gegenüber der magnetischen Entsicherungseinrichtung 10 positioniert werden.

Es sei angemerkt, dass die Entsicherungseinrichtung 10, wie in Fig. 9 gezeigt, einteilig ausgebildet sein kann. Alternativ kann diese aus mehreren Teilen bestehen, die jeweils einzeln relativ zum ersten Gehäuseteil 3 positioniert werden müssen.

In der Entsicherungseinrichtung 10 sind den jeweiligen Sicherungsmitteln 5 bzw. Riegeln 5.2 zugeordnete Magnetelemente 10.2 vorgesehen. Nach dem Einlegen in die Entsicherungseinrichtung 10 sind die jeweiligen Sicherungsmittel 5 mit deren magnetischen oder magnetisierbaren Elementen 5.1 derart relativ zu den Magnetelementen 10.2 angeordnet, dass die jeweiligen Magnetelemente 10.2 aufgrund des Magnetfeldes eine Kraft auf die Elemente 5.1 ausüben, so dass die Riegel 5.2, wie in Fig. 14 gezeigt, in die Entsicherungsstellung bewegt oder zurückgezogen werden.

Anschließend kann das zweite Gehäuseteil 4 auf das erste Gehäuseteil aufgesetzt und fixiert werden. Hierzu wird das zweite Gehäuseteil 4 in einer ersten Raumrichtung, im gezeigten Ausführungsbeispiel in negativer z-Richtung, auf das erste Gehäuseteil 3 aufgesetzt, wie dies mit dem Pfeil l angedeutet ist. Durch diese Aufsetzbewegung kommt der zweite Gehäuseteil 4 mit dessen Anlagefläche 4.3 gegenüber der Dichtung 6 zur Anlage. Die Vorsprünge 4.2 werden dabei durch die Öffnung 3.2, insbesondere den ersten Öffnungsabschnitt 3.2.1, hindurchgesteckt.

Anschließend wird der zweite Gehäuseteil 4 relativ zum ersten Gehäuseteil 3 in einer zweiten Raumrichtung, die quer zur ersten Raumrichtung verläuft, verschoben. Im Ausführungsbeispiel entspricht diese zweite Raumrichtung der positiven y-Richtung. Dadurch wird ein Formschluss zwischen den Vorsprüngen 4.2 und den Öffnungen 3.2 erreicht, d.h. die Vorsprünge hintergreifen Abschnitte der Öffnungen. Dies ist beispielhaft in Fig. 13 zu erkennen.

Um ein unerwünschtes Lösen der formschlüssigen Verbindung zwischen erstem und zweiten Gehäuseteil 3, 4 zu vermeiden, insbesondere eine Verschiebung des zweiten Gehäuseteils 4 relativ zum ersten Gehäuseteil 3 zu vermeiden, werden nach dem Herstellen der formschlüssigen Verbindung die Sicherungsmittel 5 aktiviert, d.h. in die Sicherungsstellung positioniert.

Dieses Aktivieren der Sicherungsmittel 5 erfolgt dadurch, dass das Gehäuse 1, d.h. der erste Gehäuseteil 3 mit dem daran fixierten zweiten Gehäuseteil 4 aus der Entsicherungseinrichtung 10 herausgenommen wird. Durch das Beabstanden des Gehäuses 1 von der Entsicherungseinrichtung 10 schwächt sich das auf die Sicherungsmittel 5 einwirkende Magnetfeld ab und die Sicherungsmittel bewegen sich aufgrund der Federbelastung in die Sicherungsstellung bzw. Verriegelungsposition. Somit kann nach dem Entnehmen des Gehäuses 1 aus der Entsicherungseinrichtung 10 der zweite Gehäuseteil 4 nicht mehr relativ zum ersten Gehäuseteil 3 bewegt, insbesondere verschoben werden.

Das Öffnen des Gehäuses 1, d.h. das Abnehmen des zweiten Gehäuseteils 4 vom ersten Gehäuseteil 3 erfolgt in analoger Weise, nämlich durch Anordnen des Gehäuses 1 an der magnetischen Entsicherungseinrichtung 10, um die Sicherungsmittel 5 in die Entsicherungsstellung zu bewegen, Verschieben des zweiten Gehäuseteils 4 relativ zum ersten Gehäuseteil 3 und Abheben des zweiten Gehäuseteils 4 nach dieser Verschiebungsbewegung.

Wie insbesondere in den Figuren 8, 10 und 15 zu erkennen, ist an der Schnittstelle zwischen dem ersten und zweiten Gehäuseteil 3, 4 umlaufend eine Dichtung 6 vorgesehen. Durch die Dichtung 6 wird eine Flüssigkeitsdichtigkeit des Gehäuses 1 erreicht. Hierbei bedeutet "flüssigkeitsdicht" insbesondere, dass die Schnittstelle zwischen erstem und zweitem Gehäuseteil 3, 4 staubdicht und geschützt gegen Strahlwasser aus einem beliebigen Winkel ist (IP65- Schutzart).

Um eine sichere Abdichtung der Schnittstelle zu erhalten, jedoch trotzdem den zweiten Gehäuseteil 4 relativ zum ersten Gehäuseteil verschieben zu können ohne dass sich die Dichtung verschiebt, sind folgende Ausbildungen vorteilhaft. Die Dichtung 6 ist einstückig umlaufend ausgebildet und in eine Sicke des ersten Gehäuseteils 3 oder zweiten Gehäuseteils 4 teilweise eingesetzt. Vorzugsweise ist mehr als 50% der Höhe der Dichtung in die Sicke eingesetzt, so dass die Dichtung 6 mit deren kleineren Anteil der Höhe über die Sicke vorsteht. Zudem ist die Dichtung 6 vorteilhafterweise in der Sicke klemmend oder und/oder stoffschlüssig fixiert, so dass sich die Dichtung 6 beim Verschieben der Gehäuseteile 3, 4 gegeneinander nicht aus der Sicke herauslösen kann.

Die Dichtung weist vorteilhafterweise einen halbrunden oder halbkreisförmigen Querschnitt auf, wobei eine Flachseite der Dichtung 6 in der Sicke aufgenommen ist und die Rundung der Dichtung 6 oberseitig über die Sicke übersteht. Dadurch wird eine bessere Verschiebbarkeit der Gehäuseteile 3, 4 relativ zueinander erreicht. Zudem kann die Dichtung eine Gleitschicht aufweisen, beispielsweise aufgebracht durch ein Gleitspray o.ä., um die Gleitfähigkeit zu verbessern.

Durch die Herstellung der formschlüssigen Verbindung zwischen dem ersten und zweiten Gehäuseteil 3, 4 wird vorzugsweise eines der Gehäuseteile 3, 4, insbesondere das zweite Gehäuseteil 4, gegen die Dichtung 6 angepresst, um dadurch die Dichtigkeit des Gehäuses 1 zu erreichen.

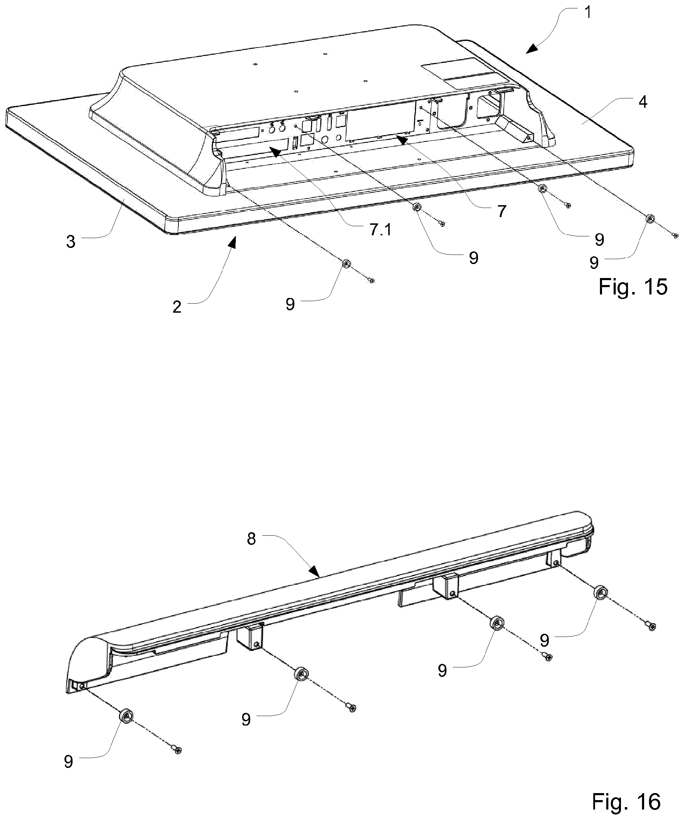

Fig. 15 bis 18 zeigen ein Ausführungsbeispiel des Gehäuses 1, bei dem das zweite Gehäuseteil 4 einen lösbar fixierbaren Gehäusedeckel 8 aufweist. Der Gehäusedeckel 8 ist insbesondere dazu vorgesehen, einen Anschlussbereich 7, an dem beispielsweise mehrere Steckverbindungsstellen 7.1 vorgesehen sind, abzudecken bzw. zu verschließen. Hierzu weist das zweite Gehäuseteil 4 eine Ausnehmung bzw. Öffnung auf, in die der Gehäusedeckel 8 einsetzbar ist.

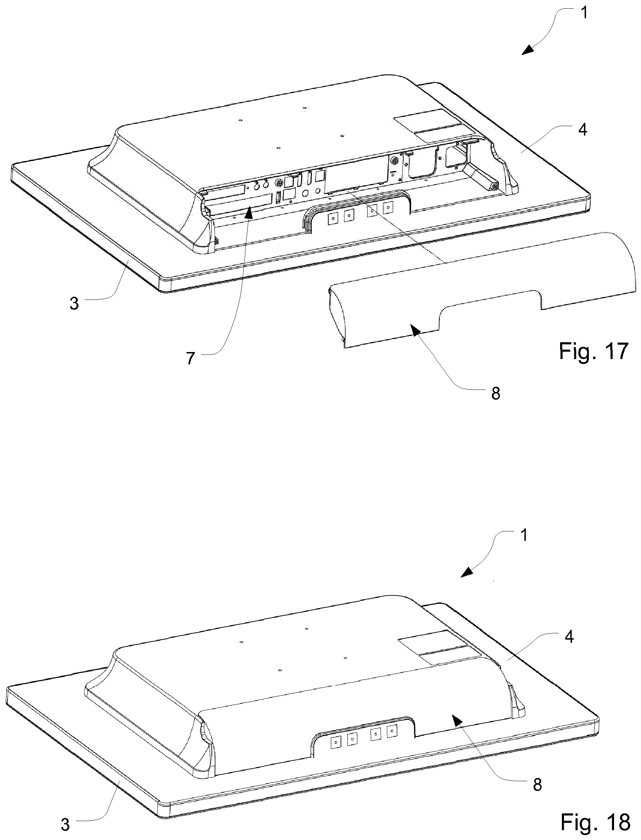

Zur Fixierung des Gehäusedeckels 8 an dem zweiten Gehäuseteil 4 weist der Gehäusedeckel 8 und/oder das zweite Gehäuseteil 4 mehrere Magnetelemente 9 auf. Vorzugsweise sind sowohl am Gehäusedeckel 8 als auch am zweiten Gehäuseteil 4 jeweils miteinander zusammenwirkende und örtlich korrespondierend angeordnete Magnetelemente 9 vorgesehen. Dadurch wird der Gehäusedeckels 8 nach Aufsetzen auf das zweite Gehäuseteil 4 (Fig. 17) magnetisch an dem zweiten Gehäuseteil 4 gehalten, wie dies in Fig. 18 gezeigt ist.

Das Gehäuse 1 kann zumindest teilweise aus einem Aluminiumdruckguss gefertigt sein. Insbesondere der erste und/oder zweite Gehäuseteil 3, 4 und/oder der Gehäusedeckel 8 können mittels eines Aluminiumdruckguss-Verfahrens hergestellt sein.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrunde liegende, durch die Patentansprüche festgelegte Schutzbereich verlassen wird.

### Bezugszeichenliste

- 1: Gehäuse
- 2: Anzeigeeinheit
- 3: erster Gehäuseteil
- 3.1: erste Verbindungsmittel
- 3.2: Öffnung
- 3.2.1: erster Öffnungsabschnitt
- 3.2.2: zweiter Öffnungsabschnitt
- 3.3: Anlagebereich
- 4: zweiter Gehäuseteil
- 4.1: zweite Verbindungsmittel
- 4.2: Vorsprung
- 4.2.1: erster Zapfenteil
- 4.2.2: zweiter Zapfenteil
- 4.3: Anlagefläche
- 4.4: Ausnehmung
- 5: Sicherungsmittel
- 5.1: magnetisches oder magnetisierbares Element
- 5.2: Riegel
- 5.3: Spiralfeder
- 6: Dichtung
- 7: Anschlussbereich
- 7.1: Steckverbindungsstelle
- 8: Gehäusedeckel
- 9: Magnetelement
- 10: magnetische Entsicherungseinrichtung
- 10.1: Anlageabschnitt
- 10.1.1: bodenseitiger Anlageabschnittsbereich
- 10.1.2: seitlicher Anlageabschnittsbereich
- 10.2: Magnetelement

- d: Durchmesser
- b: Breite

## Patentansprüche

1. Medizintechnisches Gerät in Form eines Monitors mit einem Gehäuse oder eines Computers, bei dem die Rechnerhardware sowie eine berührungsempfindliche Anzeigeeinheit in ein gemeinsames Gehäuse integriert sind, wobei das Gehäuse (1) zumindest einen ersten Gehäuseteil (3) und einen mit dem ersten Gehäuseteil (3) lösbar verbindbaren zweiten Gehäuseteil (4) umfasst, wobei der erste Gehäuseteil (3) erste Verbindungsmittel (3.1) und der zweite Gehäuseteil (4) mit diesen ersten Verbindungsmitteln (3.1) zusammenwirkende zweite Verbindungsmittel (4.1) aufweisen, wobei die ersten und zweiten Verbindungsmittel (3.1, 4.1) dazu ausgebildet sind, eine Fixierung des zweiten Gehäuseteils (4) am ersten Gehäuseteil (3) durch eine formschlüssige Verbindung zu bewirken, wobei die formschlüssige Verbindung durch ein Verhaken oder Verzahnen der Gehäuseteile (3, 4) ineinander bewirkt wird, wobei der zweite Gehäuseteil (4) am ersten Gehäuseteil (3) durch Aufsetzen in einer ersten Raumrichtung und durch Verschieben in einer zweiten, quer zur ersten Raumrichtung verlaufenden Raumrichtung fixierbar ist, wobei Sicherungsmittel (5) vorgesehen sind, die zur Sicherung der Fixierung des zweiten Gehäuseteils (4) am ersten Gehäuseteil (3) ausgebildet sind, wobei die Sicherungsmittel (5) ein magnetisches oder magnetisierbares Element (5.1) aufweisen, das zum Zusammenwirken mit einer magnetischen Entsicherungseinrichtung (6) ausgebildet ist, und zwar derart, dass die Sicherungsmittel (5) durch das Magnetfeld der magnetischen Entsicherungseinrichtung (6) aus einer Sicherungsstellung in eine Entsicherungsstellung bewegbar sind, wobei an der Schnittstelle zwischen dem ersten und zweiten Gehäuseteil (3, 4) eine Dichtung (6) vorgesehen ist, die bei Fixierung des zweiten Gehäuseteils (4) am ersten Gehäuseteil (3) die Schnittstelle flüssigkeitsdicht abdichtet, wobei die Dichtung (6) einstückig umlaufend ausgebildet und in eine Sicke des ersten Gehäuseteils (3) oder des zweiten Gehäuseteils (4) teilweise eingesetzt ist, wobei durch die formschlüssige Verbindung der Gehäuseteile (3, 4) gegeneinander ein Anpressdruck der Gehäuseteile (3, 4) gegenüber dieser Dichtung (6) erreicht wird, so dass die Schnittstelle zwischen den Gehäuseteilen (3, 4) fluiddicht ausgebildet ist.

2. Gerät nach Anspruch 1, wobei die Sicherungsmittel (5) einen Riegel (5.2) aufweisen, der federbelastet ohne Einwirkung äußerer Kräfte in die Sicherungsstellung positioniert ist.

3. Gerät nach Anspruch 2, wobei der Riegel (5.2) verschiebbar, verschwenkbar oder in einer kombinierten Schiebe-Schwenkbewegung bewegbar ist.

4. Gerät nach Anspruch 2 oder 3, wobei der Riegel (5.2) mit dem magnetischen oder magnetisierbaren Element (5.1) mechanisch gekoppelt ist, wobei das magnetische oder magnetisierbare Element (5.1) zum Zusammenwirken mit der magnetischen Entsicherungseinrichtung (10) ausgebildet ist, und zwar derart, dass durch die von der magnetischen Entsicherungseinrichtung (10) auf das magnetische oder magnetisierbare Element (5.1) ausgeübten Kräfte der Riegel (5.2) aus Sicherungsstellung in die Entsicherungsstellung bewegbar ist.

5. Gerät nach einem der Ansprüche 2 bis 4, wobei der Riegel (5.2) in der Sicherungsstellung zum Eingreifen in eine am zweiten Gehäuseteil (4) ausgebildete Ausnehmung (4.4) vorgesehen ist oder einen Vorsprung oder eine Hinterschneidung, die am zweiten Gehäuseteil (4) vorgesehen ist, in der Sicherungsstellung hintergreift.

6. Gerät nach einem der vorhergehenden Ansprüche, wobei der erste Gehäuseteil (3) als erste Verbindungsmittel (3.1) Öffnungen (3.2) aufweist, in die am zweiten Gehäuseteil (4) als zweite Verbindungsmittel (4.1) vorgesehene Vorsprünge (4.2) formschlüssig eingreifen, oder,
dass das zweite Gehäuseteil (4) als zweite Verbindungsmittel (4.1) Öffnungen aufweist, in die am ersten Gehäuseteil (3) als erste Verbindungsmittel (3.1) vorgesehene Vorsprünge formschlüssig eingreifen.

7. Gerät nach einem der vorhergehenden Ansprüche, wobei die formschlüssige Verbindung des zweiten Gehäuseteils (4) am ersten Gehäuseteil (3) durch einen abschnittsweise eine Hinterschneidung hintergreifenden Vorsprung (4.2) erfolgt.

8. Gerät nach einem der vorhergehenden Ansprüche, wobei die formschlüssige Verbindung des zweiten Gehäuseteils (4) am ersten Gehäuseteil (3) durch mehrere pilzkopfförmige oder schwalbenschwanzartig ausgebildete Vorsprünge (4.2) erfolgt, die in mit diesen Vorsprüngen (4.2) zusammenwirkende Ausnehmungen oder Öffnungen (3.2) eingreifen.

9. Gerät nach einem der vorhergehenden Ansprüche, wobei die erste und zweite Raumrichtung senkrecht zueinander verlaufen.

10. Gerät nach einem der vorhergehenden Ansprüche, wobei bei Fixierung des zweiten Gehäuseteils (4) am ersten Gehäuseteil (3) der Übergang zwischen dem ersten und zweiten Gehäuseteil (3, 4) flächenbündig ausgebildet ist.

11. Gerät nach einem der vorhergehenden Ansprüche, wobei am zweiten Gehäuseteil (4) zumindest ein Anschlussbereich (7) mit zumindest einer Steckverbindungsschnittstelle (7.1) vorgesehen ist und dass zum Verschließen des Anschlussbereichs (7) ein Gehäusedeckel (8) vorgesehen ist, der magnetisch am zweiten Gehäuseteil (4) fixierbar ist.

## Claims

1. A medical device in the form of a monitor with a housing or a computer, which comprises computer hardware and a touch-sensitive display unit integrated in a common housing, wherein the housing (1) comprises at least a first housing part (3) and a second housing part (4) releasably connectable to the first housing part (3), wherein the first housing part (3) includes first connecting means (3.1) and the second housing part (4) includes second connecting means (4.1) interacting with said first connecting means (3.1), wherein the first and second connecting means (3.1, 4.1) are configured to cause a fixing of the second housing part (4) on the first housing part (3) by means of a form-fitting connection, wherein the form-fitting connection is caused by interlocking the housing parts (3, 4) in a toothed or hooked manner, wherein the second housing part (4) can be fixed on the first housing part (3) by placement in a first spatial direction and by shifting in a second spatial direction extending transversely to the first spatial direction, wherein securing means (5) configured to secure the fixing of the second housing part (4) on the first housing part (3) are provided, wherein the securing means (5) include a magnetic or magnetizable element (5.1) configured to interact with a magnetic unlocking device (6) in such a way that the securing means (5) can be moved from a locking position to an unlocking position by the magnetic field of the magnetic unlocking device (6), wherein a seal (6) is provided at the interface between the first and second housing parts (3, 4), wherein said seal (6) seals the interface in a liquid-tight manner when the second housing part (4) is fixed to the first housing part (3) and the seal (6) is formed circumferentially in one piece formed and is partially inserted into a beading of the first housing part (3) or the second housing part (4), wherein due to the form-fitting connection of the housing parts (3, 4) against each other a contact pressure of the housing parts (3, 4) against this seal (6) is obtained so that the interface between the housing parts (3, 4) is fluid-tight.

2. The device according to claim 1, wherein the securing means (5) include a bolt (5.2) which is spring-loaded into the securing position without the action of external forces.

3. The device according to claim 2, wherein the bolt (5.2) can be moved in a sliding manner, in a pivoting manner or in a combined sliding-pivoting movement.

4. The device according to claim 2 or 3, wherein the bolt (5.2) is mechanically coupled to the magnetic or magnetizable element (5.1), wherein the magnetic or magnetizable element (5.1) is configured to interact with the magnetic unlocking device (10) in such a way that, due to the forces exerted by the magnetic unlocking device (10) on the magnetic or magnetizable element (5.1), the bolt (5.2) can be moved from the locked position to the unlocked position.

5. The device according to one of claims 2 to 4, wherein the bolt (5.2) is configured to engage in a recess (4.4) formed on the second housing part (4) in the secured position or engages behind a projection or an undercut provided on the second housing part (4) in the secured position.

6. The device according to one of the preceding claims, wherein the first housing part (3) has openings (3.2) as first connecting means (3.1) in which projections (4.2) provided on the second housing part (4) as second connecting means (4.1) engage in a form-fitting manner, or
the second housing part (4) has openings as second connecting means (4.1) in which projections provided on the first housing part (3) as first connecting means (3.1) engage in a form-fitting manner.

7. The device according to one of the preceding claims, wherein the form-fitting connection of the second housing part (4) to the first housing part (3) is effected by a projection (4.2) engaging behind an undercut in sections.

8. The device according to one of the preceding claims, wherein the form-fitting connection of the second housing part (4) to the first housing part (3) is effected by a plurality of mushroom-shaped or dovetail-like projections (4.2) which are engaging in recesses or openings (3.2) interacting with said projections (4.2).

9. The device according to one of the preceding claims, wherein the first and second spatial directions extend perpendicularly to one another.

10. The device according to one of the preceding claims, wherein, when the second housing part (4) is fixed on the first housing part (3), the transition between the first and second housing parts (3, 4) is formed to be flush.

11. The device according to one of the preceding claims, wherein at least one connection area (7) with at least one plug connection interface (7.1) is provided on the second housing part (4) and a housing cover (8) magnetically fixable on the second housing part (4) is provided for closing the connection area (7).

## Revendications

1. Appareil médical sous la forme d'un moniteur ayant un boîtier ou sous la forme d'un ordinateur, dans lequel le matériel informatique et une unité d'affichage tactile sont intégrés dans un boîtier commun, le boîtier (1) comprenant au moins une première partie de boîtier (3) et une seconde partie de boîtier (4) qui peut être reliée de manière amovible à la première partie de boîtier (3), la première partie de boîtier (3) présentant des premiers moyens de liaison (3.1) et la seconde partie de boîtier (4) présentant des seconds moyens de liaison (4.1) coopérant avec lesdits premiers moyens de liaison (3.1), les premiers et seconds moyens de liaison (3.1, 4. 1) étant réalisés pour procurer une fixation de la seconde partie de boîtier (4) à la première partie de boîtier (3) au moyen d'une liaison par coopération de forme, la coopération de forme étant assurée par un accrochage ou un engrènement des parties de boîtier (3, 4) l'une dans l'autre, la seconde partie de boîtier (4) pouvant être fixée à la première partie de boîtier (3) en étant placée dans une première direction spatiale et en étant déplacée dans une seconde direction spatiale s'étendant transversalement à la première direction spatiale, des moyens de blocage (5) étant prévus qui sont réalisés pour bloquer la fixation de la seconde partie de boîtier (4) à la première partie de boîtier (3), les moyens de blocage (5) présentant un élément magnétique ou magnétisable (5.1) qui est réalisé pour coopérer avec un dispositif de déblocage magnétique (6), de telle sorte que les moyens de blocage (5) peuvent être déplacés par le champ magnétique du dispositif de déblocage magnétique (6) depuis une position de blocage jusque dans une position de déblocage, un joint d'étanchéité (6) étant prévu à l'interface entre la première et la seconde partie de boîtier (3, 4), qui étanchéifie l'interface de manière étanche aux liquides lorsque la seconde partie de boîtier (4) est fixée à la première partie de boîtier (3), le joint d'étanchéité (6) étant réalisé d'une seule pièce sur la circonférence et étant partiellement inséré dans une moulure de la première partie de boîtier (3) ou de la seconde partie de boîtier (4), une pression de contact des parties de boîtier (3, 4) par rapport audit joint d'étanchéité (6) étant obtenue par la liaison par coopération de forme des parties de boîtier (3, 4) entre elles, de sorte que l'interface entre les parties de boîtier (3, 4) est réalisée de manière étanche aux fluides.

2. Appareil selon la revendication 1, dans lequel les moyens de blocage (5) présentent un verrou (5.2) qui est positionné dans une position de blocage sous la charge d'un ressort et sans l'action de forces externes.

3. Appareil selon la revendication 2, dans lequel le verrou (5.2) est mobile en coulissement et en pivotement ou est mobile en un mouvement combiné de coulissement-pivotement.

4. Appareil selon la revendication 2 ou 3, dans lequel le verrou (5.2) est couplé mécaniquement à l'élément magnétique ou magnétisable (5.1), l'élément magnétique ou magnétisable (5.1) étant réalisé pour coopérer avec le dispositif de déblocage magnétique (10), de telle sorte que le verrou (5.2) peut être déplacé de la position de blocage jusque dans la position de déblocage par les forces exercées par le dispositif de déblocage magnétique (10) sur l'élément magnétique ou magnétisable (5.1).

5. Appareil selon l'une des revendications 2 à 4, dans lequel le verrou (5.2) dans la position de blocage est prévu pour s'engager dans un évidement (4.4) ménagé sur la seconde partie de boîtier (4) ou engage par l'arrière une saillie ou une contre-dépouille, prévue sur la seconde partie de boîtier (4), dans la position de blocage.

6. Appareil selon l'une des revendications précédentes, dans lequel la première partie de boîtier (3) présente des ouvertures (3.2) en tant que premiers moyens de liaison (3.1), dans lesquelles s'engagent par coopération de forme des saillies (4.2) prévues en tant que seconds moyens de liaison (4.1) sur la seconde partie de boîtier (4), ou,
la seconde partie de boîtier (4) présente des ouvertures en tant que seconds moyens de liaison (4.1), dans lesquelles s'engagent par coopération de forme des saillies prévues en tant que premiers moyens de liaison (3.1) sur la première partie de boîtier (3).

7. Appareil selon l'une des revendications précédentes, dans lequel la liaison par coopération de forme de la seconde partie de boîtier (4) avec la première partie de boîtier (3) est réalisée par une saillie (4.2) engageant par l'arrière localement une contre-dépouille.

8. Appareil selon l'une des revendications précédentes, dans lequel la liaison par coopération de forme de la seconde partie de boîtier (4) avec la première partie de boîtier (3) est réalisée par une pluralité de saillies (4.2) réalisées en forme de tête de champignon ou de queue d'aronde qui s'engagent dans des évidements ou des ouvertures (3.2) coopérant avec lesdites saillies (4.2).

9. Appareil selon l'une des revendications précédentes, dans lequel les première et seconde directions spatiales s'étendent perpendiculairement l'une à l'autre.

10. Appareil selon l'une des revendications précédentes, dans lequel, la seconde partie de boîtier (4) étant fixée à la première partie de boîtier (3), la transition entre la première et la seconde partie de boîtier (3, 4) est réalisée en affleurement.

11. Appareil selon l'une des revendications précédentes, dans lequel est prévu, sur la seconde partie de boîtier (4), au moins une zone de raccordement (7) ayant au moins une interface de liaison par enfichage (7.1), et un couvercle de boîtier (8) est prévu pour refermer la zone de raccordement (7), couvercle qui peut être fixé par voie magnétique à la seconde partie de boîtier (4).
